# FASCICULE DE BREVET EUROPEEN

(11) **EP 2 950 347 B1**
(45) Date de publication et mention de la délivrance du brevet: **17.10.2018**
(21) Numéro de dépôt: 15169098.9
(22) Date de dépôt: 26.05.2015
(51) Int. Cl.: H01L 27/146, H01L 31/0296, H01L 31/103, H01L 31/18, H01L 27/144, H01L 31/0352

(54) **MATRICE DE PHOTODIODES MESA A FTM AMELIOREE**
MESA-PHOTODIODEN-MATRIX MIT VERBESSERTER MTF
MESA PHOTODIODE ARRAY WITH IMPROVED MTF

(30) Priorité: 27.05.2014 FR 1401208
(43) Date de publication de la demande: 02.12.2015
(73) Titulaire: Commissariat à l'Énergie Atomique et aux Énergies Alternatives, 75015 Paris (FR)
(72) Inventeur: Mollard, Laurent, 38640 CLAIX (FR); Baier, Nicolas, 38330 SAINT-NAZAIRE LES EYMES (FR)
(74) Mandataire: Brevalex

(56) Documents cités:
- EP-A1- 0 350 351
- JP-A- S62 119 976
- US-A- 4 639 756
- US-A- 4 961 098
- US-A- 5 880 510

## Description

### DOMAINE TECHNIQUE

La présente invention concerne le domaine des photodiodes à base de matériau CdHgTe, utilisées notamment pour détecter un rayonnement infrarouge.

### ÉTAT DE LA TECHNIQUE ANTÉRIEURE

On connaît dans l'art antérieur différentes géométries de photodiodes, notamment les photodiodes dites « mésa ». Une photodiode mésa présente une géométrie non planaire, dans laquelle une couche en matériau semi-conducteur, nommée « couche utile », présente une face inférieure généralement plane, et une face supérieure en forme de plot. La face inférieure peut être déposée sur un substrat. Chaque plot présente des parois latérales et une paroi supérieure du côté opposé à la face inférieure de la couche utile. On nomme « mésa » un tel plot, en référence à sa forme généralement en plateau.

Une zone est dite dopée P lorsqu'elle présente un excès de « trous », ou en d'autres termes un défaut d'électrons (porteurs minoritaires). Une zone est dite dopée N lorsqu'elle présente un excès d'électrons, ou en d'autres termes un défaut de trous (porteurs minoritaires). Dans tout le texte, la nature du dopage d'une zone dopée désigne la nature des porteurs minoritaires dans ladite zone. Un dopage P peut être réalisé par implantation d'un élément dopant dit accepteur, c'est-à-dire recevant au moins un électron de façon à créer un défaut d'électron. Un dopage N peut être réalisé par implantation d'un élément dopant dit donneur, c'est-à-dire donnant au moins un électron de façon à créer un défaut de trou.

Du côté de ladite paroi supérieure, le plot présente une région présentant un dopage N ou P, de nature différente de celle du dopage dans le restant de la couche utile, formant ainsi une jonction PN. Une jonction PN forme une photodiode.

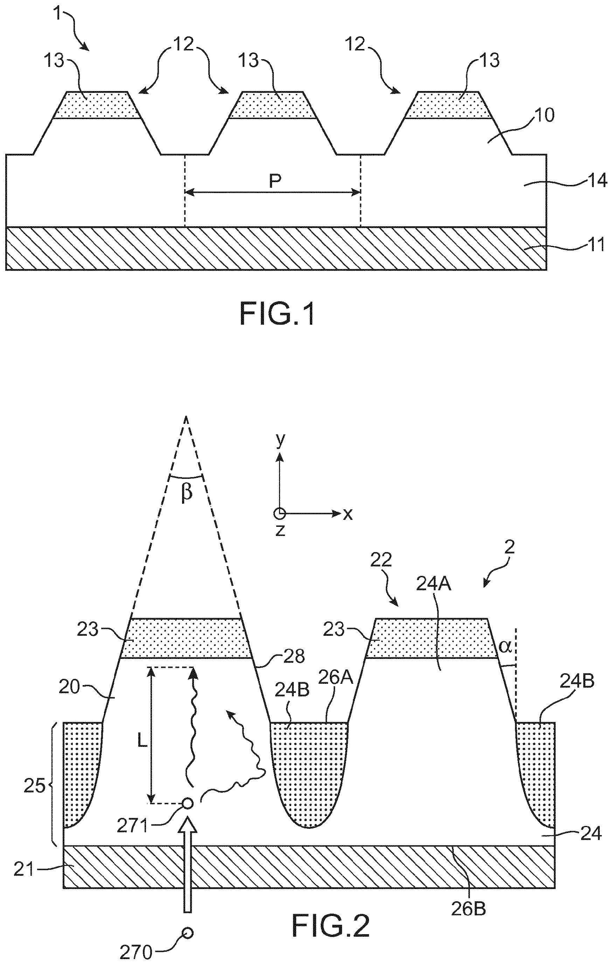

En pratique, on fabrique des matrices de plusieurs photodiodes mésa. On a représenté en figure 1 un exemple d'une telle matrice, vue en coupe. La matrice 1 comprend une couche utile 10 déposée sur un substrat 11 (représenté hachuré). La couche utile 10 a été gravée de façon à former des plots 12. Chaque plot 12 présente une jonction PN entre une première zone 14 présentant un premier dopage N ou P, et une deuxième zone 13 présentant un deuxième dopage P ou N de nature différente de celle du premier dopage. Chaque plot présente une jonction PN qui lui est propre, et forme ainsi une photodiode.

On réalise par exemple des matrices rectangulaires regroupant 640x512 photodiodes, pour un pas P de 15 µm (largeur d'une photodiode).

Les documents US5880510A et EP0350351A1 divulguent une matrice de photodiode mésa, dans laquelle la couche utile consiste en un alliage semi-conducteur de type CdₓHg₁₋ₓTe.

L'invention concerne plus particulièrement une matrice de photodiode mésa, dans laquelle la couche utile est réalisée dans un matériau semi-conducteur fait d'un alliage de cadmium, mercure et tellure CdₓHg₁₋ₓTe, avec x un réel compris entre 0 et 1, les bornes étant exclues.

L'une des grandeurs caractéristiques de la qualité optique d'une matrice de photodiodes est sa fonction de transfert de modulation (FTM). Elle est généralement représentée par un graphique représentant un rapport entre un contraste mesuré et un contraste théorique, en fonction d'une fréquence (ici l'inverse du pas P de la matrice de photodiodes). La FTM illustre la capacité de la matrice de photodiodes à transcrire fidèlement une répartition de photons incidents, sous la forme d'une carte de courants mesurés sur les photodiodes. Il est donc avantageux qu'une matrice de photodiodes présente une bonne FTM, afin qu'elle offre une image qui transcrit fidèlement la réalité.

Un objectif de la présente invention est de proposer une matrice de photodiodes mésa dont la couche utile est en CdₓHg₁₋ₓTe, présentant une FTM améliorée.

Un autre but de la présente invention est de proposer un procédé de fabrication d'une matrice de photodiodes, permettant d'obtenir une matrice de photodiodes mésa dont la couche utile est en CdₓHg₁₋ₓTe et présentant une FTM améliorée.

### EXPOSÉ DE L'INVENTION

Cet objectif est atteint avec une matrice d'au moins deux photodiodes selon la revendication 1.

Avantageusement, au moins une deuxième région s'étend depuis la face supérieure de la couche utile, jusqu'à une face inférieure de la couche utile, du côté opposé aux plots. La face supérieure de la couche utile est la face recevant les plots.

La deuxième région peut s'étendre depuis la face supérieure de la couche utile, et au moins jusqu'à une profondeur correspondant à la moitié de la distance séparant les faces supérieure et inférieure, entre deux plots.

Au moins une deuxième région peut s'étendre entre deux plots voisins et sur au moins une portion des surfaces latérales desdits deux plots voisins.

La deuxième densité de dopage est avantageusement au moins deux fois supérieure à la première densité de dopage.

La deuxième densité de dopage peut être au moins dix fois supérieure à la première densité de dopage.

Selon un premier mode de réalisation de l'invention, la première zone dopée est dopée N et les deuxièmes zones dopées sont dopées P.

Selon ce premier mode de réalisation de l'invention, la deuxième zone dopée peut s'étendre en outre sur les parois latérales d'un plot, et présenter une concentration en cadmium supérieure à la concentration en cadmium dans la première zone dopée.

De préférence, la couche utile est recouverte, du côté des plots, par une couche présentant une concentration en cadmium supérieure à celle de la couche utile. Cette concentration est avantageusement une concentration volumique moyenne. Il s'agit d'une couche non dopée.

Selon un deuxième mode de réalisation de l'invention, la première zone dopée est dopée P et les deuxièmes zones dopées sont dopées N, et l'au moins une deuxième région présente une concentration en cadmium supérieure à la concentration en cadmium dans la première région.

L'invention concerne également un procédé de fabrication d'une matrice d'au moins deux photodiodes selon la revendication 10.

Selon un premier mode de réalisation du procédé selon l'invention, l'étape de création d'au moins une jonction PN met en oeuvre une implantation ionique d'un dopant donneur, l'étape supplémentaire de dopage met en oeuvre une implantation ionique d'un dopant accepteur, et le procédé comprend en outre les étapes suivantes :
- dépôt, sur la couche utile, d'une couche, dite couche de réservoir, présentant une concentration en cadmium supérieure à celle de la couche utile ;
- recuit de la couche utile recouverte de la couche de réservoir réalisant une diffusion des atomes de cadmium de la couche de réservoir, depuis la couche de réservoir vers la couche utile.

Selon ce premier mode de réalisation du procédé selon l'invention, le procédé peut comprendre une étape de gravure d'une portion de la couche de réservoir située au-dessus des plots, cette étape étant réalisée avant le recuit.

Selon un deuxième mode de réalisation du procédé selon l'invention, l'étape de création d'au moins une jonction PN met en oeuvre une implantation ionique d'un dopant accepteur sur les parois latérales et la paroi supérieure de chaque plot, et le procédé comprend en outre les étapes suivantes :
- dépôt, sur la couche utile, d'une couche, dite couche de réservoir, présentant une concentration en cadmium supérieure à celle de la couche utile ;
- recuit de la couche utile recouverte de la couche de réservoir réalisant une diffusion des atomes de cadmium de la couche de réservoir, depuis la couche de réservoir vers la couche utile.

### BRÈVE DESCRIPTION DES DESSINS

La présente invention sera mieux comprise à la lecture de la description d'exemples de réalisation donnés à titre purement indicatif et nullement limitatif, en faisant référence aux dessins annexés sur lesquels :
- la figure 1 illustre de manière schématique une matrice de photodiodes mésa selon l'art antérieur ;
- la figure 2 illustre de manière schématique un premier mode de réalisation de matrice de photodiodes mésa selon l'invention ;
- la figure 3 illustre de manière schématique un deuxième mode de réalisation de matrice de photodiodes mésa selon l'invention ;
- la figure 4 illustre de manière schématique un troisième mode de réalisation de matrice de photodiodes mésa selon l'invention ;
- la figure 5 illustre de manière schématique un premier mode de réalisation de procédé selon l'invention ;
- la figure 6 illustre de manière schématique un deuxième mode de réalisation de procédé selon l'invention ; et
- la figure 7 illustre de manière schématique un troisième mode de réalisation de procédé selon l'invention.

### EXPOSÉ DÉTAILLÉ DE MODES DE RÉALISATION PARTICULIERS

La figure 2 illustre de façon schématique, et selon une vue en coupe, un premier mode de réalisation d'une matrice 2 de photodiodes selon l'invention.

La figure 2 ne sera décrite que pour ses différences relativement à la figure 1, correspondant à l'art antérieur et décrite en introduction.

La matrice 2 comprend une couche utile 20 en matériau semi-conducteur. La couche utile 20 est formée d'un alliage de cadmium mercure et tellure de type CdₓHg₁₋ₓTe, avec x compris entre 0 et 1, les bornes étant exclues. En particulier, x est compris entre 0,2 et 0,5, par exemple 0,22.

Par exemple, on cherchera à détecter un rayonnement dans l'infrarouge moyen dit MWIR (pour l'anglais « Middle Wave InfraRed », correspondant à des longueurs d'onde comprises entre 4 µm et 5 µm), ce qui correspond, par exemple, à une concentration en cadmium définie par x=0,3.

En variante, on cherche à détecter un rayonnement dans l'infrarouge lointain dit LWIR (pour l'anglais « Long Wave InfraRed », correspondant à des longueurs d'onde comprises entre 8 et 12 µm), ce qui correspond, par exemple, à une concentration en cadmium définie par x=0,22.

En variante, on cherche à détecter un rayonnement dans l'infrarouge proche dit SWIR (pour l'anglais « Small Wave Infrared », correspondant à des longueurs d'onde entre 3 et 4 µm), ou dans l'infrarouge très lointain dit VLWIR (pour l'anglais « Very Long Wave Infrared », correspondant à des longueurs d'ondes supérieures à 14 µm).

On a représenté sur les figures le cas particulier dans lequel la matrice comprend un substrat 21, recouvert par la couche utile 20. Selon une variante non représentée, le substrat est séparé de la couche utile avant, pendant ou après la mise en oeuvre du procédé selon l'invention. Ainsi, la matrice selon l'invention ne comprend pas nécessairement un substrat.

Le substrat 21 est par exemple fait d'un alliage de cadmium, zinc, tellure. Un tel alliage offre un accord de maille très avantageux avec le matériau de la couche utile. Le substrat 21 est transparent aux longueurs d'onde que l'on souhaite détecter.

Comme dans l'art antérieur, la couche utile 20 présente :
- des plots 22, du côté d'une face supérieure 26A de la couche utile, du côté opposé au substrat ; et
- une base 25, du côté d'une face inférieure 26B de la couche utile, et formant un socle commun pour les plots.

Cette structure correspond à une matrice de photodiodes mésa, chaque plot correspondant à une photodiode.

Par exemple, la hauteur des plots est de 5 µm. En d'autres termes, la profondeur du mésa est de 5 µm. L'épaisseur de la base est par exemple de 1 µm, soit une épaisseur totale de couche utile de 6 µm.

La face inférieure 26B de la couche utile est située dans le plan horizontal (zOx). L'angle d'inclinaison des parois latérales 28 des plots, relativement à l'axe vertical (Oy), est nommé angle α. Cet angle α vaut par exemple 45°. Les parois latérales d'un plot forment ensemble un angle β, le sommet de cet angle étant dirigé du côté des plots opposé à la face inférieure 26B. On pourra prévoir toutes sortes de variantes, notamment des variantes dans lesquelles les parois latérales d'un plot forment ensemble un angle β dont le sommet est dirigé du côté de la face inférieure 26B.

Dans la couche utile 20, on distingue :
- une première zone dopée 24, formée ici dans la base ainsi que dans la partie basse de chacun des plots 22 (du côté de la face inférieure 26B et le cas échéant du substrat 21) ; et
- dans chacun des plots, une deuxième zone dopée 23 s'étendant dans la partie supérieure du plot (du côté de la face supérieure 26A).

On a donc une unique première zone dopée 24, et plusieurs deuxièmes zones dopées 23 (une pour chaque plot).

La première zone dopée 24 présente un premier dopage N ou P. Les deuxièmes zones dopées 23 présentent un deuxième dopage P ou N, de nature différente de celle du premier dopage. La première zone dopée 24 et la deuxième zone dopée 23 forment ensemble la couche utile 20.

Selon l'invention, la première zone dopée 24 consiste en :
- au moins une première région 24A, située en particulier sous chacun des plots 22, et présentant une première densité de dopage ; et
- au moins une deuxième région 24B dite sur-dopée, située entre deux plots voisins, et présentant une deuxième densité de dopage supérieure à la première densité de dopage.

De préférence, l'au moins une première région 24A est située directement sous chacun desdits plots, et au centre de chacun de ces plots.

Par « entre deux plots », on comprend avantageusement « entre deux plots et affleurant la face supérieure de la couche active en CdHgTe ».

L'au moins une deuxième région 24B forme avantageusement un maillage autour des plots.

La première région 24A et la deuxième région 24B ne sont pas superposées mais adjacentes latéralement.

On peut prévoir une unique deuxième région 24B s'étendant entre chacun des plots de la matrice de photodiodes.

En variante, la matrice de photodiodes comprend plusieurs deuxièmes régions 24B, chacune s'étendant entre deux plots voisins. Dans toute la suite, on conserve l'exemple de plusieurs deuxièmes régions 24B.

Par exemple, la densité de dopage dans la première région 24A est de 8.10¹⁵ atomes/cm³, et la densité de dopage dans les deuxièmes régions 24B est égale ou supérieure à 10¹⁶ atomes/cm³. La première région 24A et les deuxièmes régions 24B forment ensemble la première zone dopée 24.

Il se forme ainsi une barrière de potentiel entre une deuxième région 24B et une première région 24A.

En fonctionnement, un photon 270 pénètre dans la couche utile du côté de sa face inférieure 26B, et au regard d'une photodiode donnée. Ce photon entraîne l'apparition d'un porteur minoritaire 271 dans la couche utile 20. Ce porteur minoritaire 271 diffuse dans la couche utile, jusqu'à ce qu'il se recombine avec un porteur de nature différente. Si ledit porteur minoritaire traverse une jonction PN avant de se recombiner, il permet la création d'un courant mesurable. On peut nommer « zone de détection » la partie de la couche utile dans laquelle l'absorption d'un photon entraîne l'apparition d'un porteur minoritaire 271. Le porteur minoritaire présente une longueur de diffusion L, qui correspond à la distance qu'il parcourt avant de se recombiner. Lorsque la longueur de diffusion L est élevée, il existe donc un risque que le porteur minoritaire se recombine après traversée de la jonction PN d'une photodiode voisine. Ce risque est d'autant plus élevé que le pas de la matrice de photodiodes est faible au regard de la longueur de diffusion L.

Or, selon l'invention, la matrice de photodiodes présente, entre deux photodiodes voisines, une région 24B sur-dopée qui forme une barrière de potentiel pour les porteurs minoritaires. Les porteurs minoritaires sont donc empêchés de passer à travers la région 24B, ce qui évite qu'un porteur minoritaire pénètre dans la matrice de photodiode au regard d'une première photodiode, et se recombine après traversée de la jonction PN d'une photodiode voisine. Ainsi, un porteur minoritaire qui pénètre dans la matrice de photodiode au regard d'une première photodiode reste enfermé dans un couloir entre plusieurs régions 24B, et ne peut donc se recombiner qu'au niveau de la jonction PN de ladite première photodiode, en particulier après traversée de cette jonction PN.

On s'assure ainsi qu'un photon incident fasse apparaître un courant, dans la photodiode au regard de laquelle il pénètre dans la matrice de photodiodes.

On évite ainsi qu'un photon incident fasse apparaître un courant dans une photodiode autre que celle au regard de laquelle il pénètre dans la matrice de photodiodes.

Ainsi, la matrice de photodiodes selon l'invention présente une FTM améliorée.

L'invention est particulièrement avantageuse lorsque l'on souhaite que la matrice de photodiodes présente un pas inférieur à la longueur de diffusion des porteurs minoritaires. L'invention est donc particulièrement avantageuse dans le cas où les deuxièmes zones dopées 23 sont dopées P, et la première zone dopée 24 est dopée N (technologie dite « P sur N »). En effet, dans cette technologie, les porteurs minoritaires présentent une durée de vie élevée ce qui leur confère de grandes longueurs de diffusion (en comparaison avec la technologie dite « N sur P » correspondant à des zones 23 dopées N et une zone 24 dopée P). L'invention n'est cependant pas limitée à la technologie P sur N, et couvre également la technologie N sur P.

On remarque également que chaque deuxième région 24B, puisqu'elle présente la même nature de dopage que le reste de la première zone dopée 24, n'empêche pas de polariser toutes les photodiodes d'une même matrice à l'aide d'un même point de contact électrique, y compris lorsqu'elle s'étend jusqu'à la face inférieure 26B de la couche utile.

En outre, chaque deuxième région 24B ne présente pas de défauts aux interfaces avec la première région 24A, car ces deux régions diffèrent uniquement par leur densité de dopage.

On remarque en figure 2 que les deuxièmes zones dopées 23 et les deuxièmes régions 24B ne sont pas contigües, pour éviter la création d'un courant de fuite par effet tunnel entre une deuxième zone dopée N ou P et une deuxième région sur-dopée P ou N. La distance entre une deuxième zone dopée 23 et une deuxième région 24A est typiquement de l'ordre de 2 µm.

Dans l'exemple représenté en figure 2, chaque deuxième région 24B s'étend, entre deux plots 22, depuis la face supérieure 26A de la couche utile, et en direction de la face inférieure 26B. Chaque deuxième région 24B peut s'étendre jusqu'à la face inférieure 26B, le cas échéant jusqu'à être au contact du substrat. Dans ce cas, on peut définir plusieurs premières régions 24A.

Chaque deuxième région 24B peut s'étendre sur au moins la moitié de l'intervalle séparant deux plots voisins (écart entre une extrémité d'un plot, et l'extrémité du plot voisin la plus proche).

L'invention présente un intérêt accru dans le cas où la première zone dopée 24 est dopée N. Dans ce cas, on peut obtenir des deuxièmes régions 24B dégénérées, c'est-à-dire dont le niveau de fermi est situé dans la bande de conduction. On réalise ainsi une barrière de potentiel plus élevée qu'en l'absence de dégénérescence.

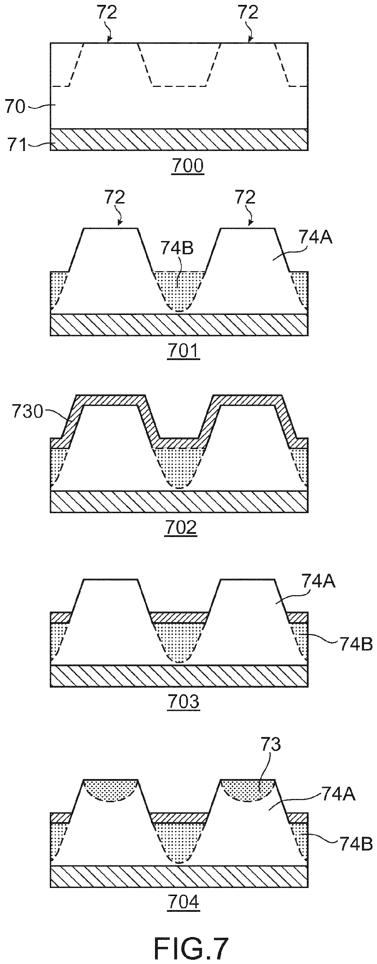

Dans le cas où la première zone dopée 24 est dopée P, il est particulièrement avantageux que les deuxièmes régions 24B présentent une concentration en cadmium supérieure à celle de la première région 24A. On a en effet observé que dans un matériau semi-conducteur en CdₓHg₁₋ₓTe, la bande interdite, nommée « gap », dépend de la concentration en cadmium. Plus cette concentration est élevée, plus le gap est élevé. La différence de concentration en cadmium entre une deuxième région 24B et la première région 24A accroît la barrière de potentiel réalisée par la différence de niveau de dopage entre ces deux régions. On a détaillé, en référence à la figure 7, un procédé selon l'invention permettant d'obtenir une telle répartition de cadmium.

La largeur de la deuxième région 24B tend à diminuer au fur et à mesure que l'on se rapproche de la face inférieure 26B.

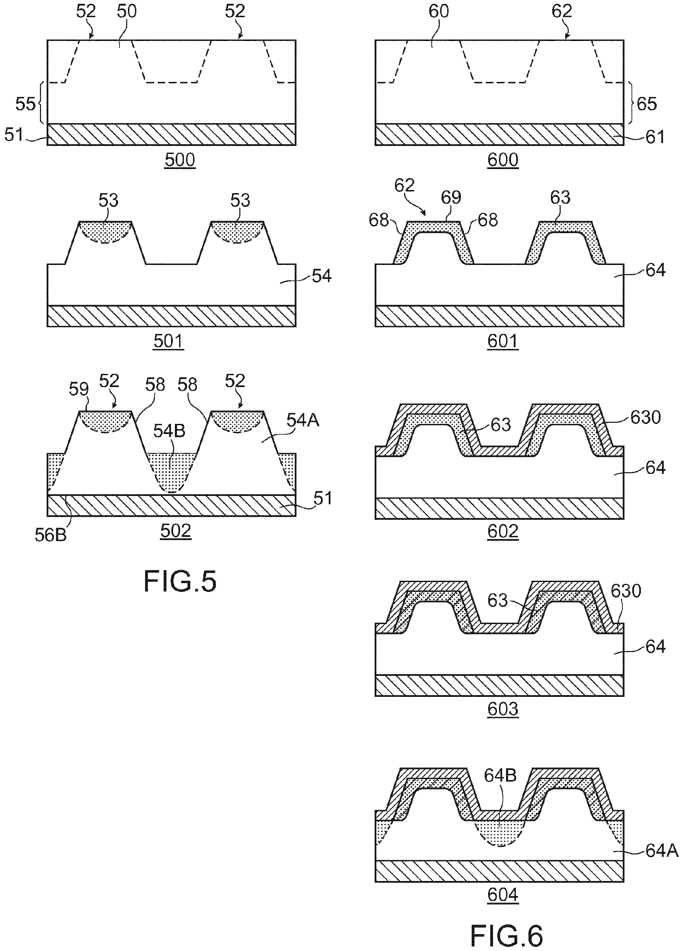

Cette forme particulière de la deuxième région 24B peut être obtenue par une implantation ionique réalisée de façon à ce que la répartition des ions implantés présente cette même forme particulière, et que la diffusion ultérieure des ions dopants implantés conserve cette forme particulière (voir figure 5).

Cette forme des deuxièmes régions 24B peut ainsi créer un guide en entonnoir pour collecter au mieux l'ensemble des porteurs minoritaires, et les guider vers la jonction PN au regard de laquelle le porteur minoritaire s'est formé.

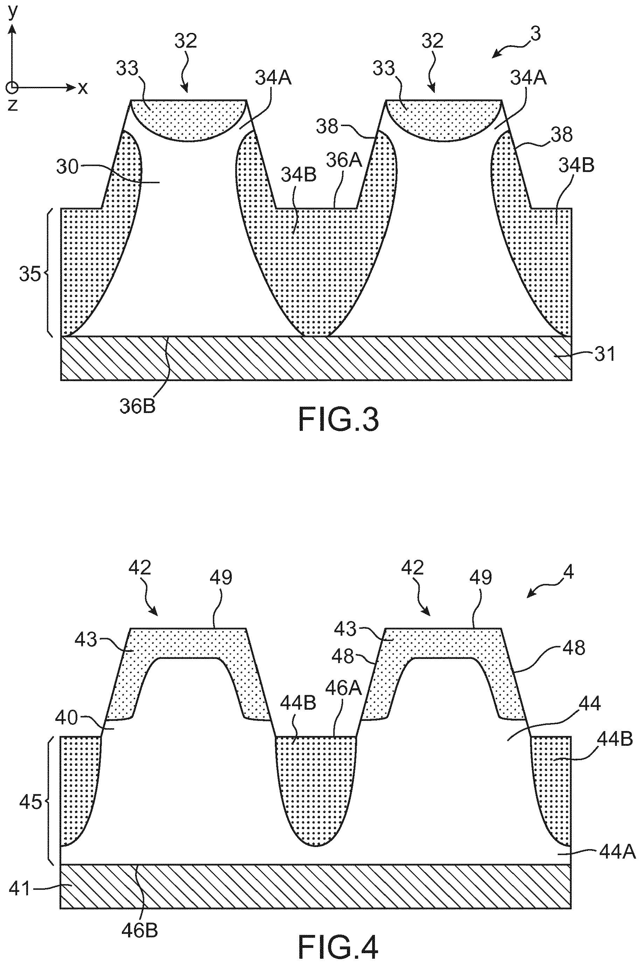

La figure 3 illustre de manière schématique un deuxième mode de réalisation d'une matrice de photodiodes selon l'invention. La figure 3 ne sera décrite que pour ses différences au regard de la figure 2.

Les références numériques 2, 20, 21, 22, 23, 24A, 24B, 25, 26A, 26B, 28 de la figure 2 correspondent respectivement aux références numériques 3, 30, 31, 32, 33, 34A, 34B, 35, 36A, 36B, 38 de la figure 3.

Les parois latérales 38 des plots sont formées par gravure dans la couche utile. Elles présentent donc des défauts de matériau, dus à la gravure.

Si des porteurs minoritaires parviennent jusqu'à ces défauts, ils se recombinent très facilement sur ces défauts. Si cette recombinaison a lieu avant que le porteur arrive jusqu'à la jonction PN d'une photodiode, elle ne donne pas lieu à la création d'un courant dans la zone de charge d'espace d'une photodiode. Ainsi, un photon incident forme bien un porteur minoritaire dans la couche utile 30, mais on ne mesure pas de courant électrique correspondant.

De même un défaut présent dans le matériau peut être à l'origine de la création de porteurs minoritaires, même sans flux photonique. Ces porteurs vont diffuser jusqu'à une zone de charge d'espace (autour de la jonction PN) et créer un courant électrique. Ce dernier phénomène va entraîner une dégradation du courant d'obscurité. La matrice de photodiodes 3 présente donc des propriétés de détection dégradées si des défauts sont présents aux abords ou dans la zone de charge d'espace d'une photodiode.

Pour pallier à cet inconvénient, on propose, dans le mode de réalisation représenté en figure 3, que chaque deuxième région 34B s'étende entre deux plots, et également sur au moins une portion des surfaces latérales 38 desdits plots. Chaque deuxième région 34B s'étend également dans l'épaisseur de la couche utile 30, sous lesdites portions de surface latérale. Les deuxièmes régions 34B entourent, au centre d'un plot, une première région 34A. Lesdites portions de surface latérale sont situées dans la partie basse des plots. Chaque partie de deuxième région 34B située sous une portion de surface latérale 38 est formée d'un seul tenant avec une partie de deuxième région 34B située entre deux plots.

En faisant remonter chaque deuxième région 34B jusque sous les parois latérales d'au moins un plot adjacent, on forme des barrières de potentiel qui empêchent les porteurs minoritaires de parvenir jusqu'aux parois latérales.

On réalise ainsi une matrice 3 de photodiodes présentant des propriétés de détection optimales.

Comme dans le mode de réalisation représenté en figure 2, les deuxièmes zones dopées 33 et les deuxièmes régions 34B ne sont pas contigües.

De même que pour le mode de réalisation représenté en figure 2, chaque deuxième région 34B peut s'étendre dans la couche utile jusqu'à sa face inférieure 36B, le cas échéant jusqu'à être en contact avec le substrat 31.

On va maintenant décrire, en référence à la figure 4, un troisième mode de réalisation de matrice de photodiodes selon l'invention. La figure 4 ne sera décrite que pour ses différences au regard de la figure 2.

Les références numériques 2, 20, 21, 22, 23, 24, 24A, 24B, 25, 26A, 26B, 28 de la figure 2 correspondent respectivement aux références numériques 4, 40, 41, 42, 43, 44, 44A, 44B, 45, 46A, 46B, 48 de la figure 4.

De même que pour le mode de réalisation représenté en figure 2, chaque deuxième région 44B peut s'étendre dans la couche utile jusqu'à sa face inférieure 46B, le cas échéant jusqu'à être en contact avec le substrat 41.

La première zone dopée 44 est dopée N, et les deuxièmes zones dopées 43 sont dopées P.

Comme expliqué en référence à la figure 3, les parois latérales 48 des plots sont formées par gravure dans la couche utile. Cette gravure peut former des défauts dans le matériau, à l'interface gravée de la couche utile. Ces défauts de matériau vont favoriser l'introduction d'un niveau d'énergie intermédiaire dans le gap du matériau. Ce niveau d'énergie intermédiaire favorise alors un franchissement spontané du gap par un électron. Ce franchissement de gap spontané crée une paire électron-trou, et donc l'apparition d'un porteur minoritaire dans la couche utile. Si ce porteur minoritaire se recombine, après traversée d'une jonction PN, on mesure un courant électrique qui ne correspond pas à l'absorption d'un photon. Ce phénomène a pour conséquence d'augmenter le courant d'obscurité. Le courant d'obscurité est le courant électrique résiduel d'un photodétecteur en l'absence d'éclairement lumineux. Ainsi un courant d'obscurité important limitera la détection de très faibles rayonnements dans l'infrarouge.

Plus le gap d'un matériau est élevé, moins il est probable que l'apparition d'un niveau d'énergie intermédiaire dans le matériau conduise à un franchissement spontané du gap par un électron. Il est donc avantageux que le gap du matériau à proximité des parois latérales 48 soit élevé.

Dans le mode de réalisation de la figure 4, on propose que pour chaque plot 42, le gap de la couche utile soit élevé à proximité des parois latérales 48. Cet effet est obtenu par une concentration en cadmium plus élevée à proximité des parois latérales 48, en comparaison avec la concentration en cadmium ailleurs dans la couche utile 40 et en particulier dans la première région dopée 44A. En effet, comme précisé précédemment, on a observé que dans un matériau en CdₓHg₁₋ₓTe, le gap dépend de la concentration en cadmium. Plus cette concentration est élevée, plus le gap est élevé.

Avantageusement, la concentration en cadmium est plus élevée à proximité des parois latérales 48 et de la paroi supérieure 49 d'un plot, et la zone présentant une concentration en cadmium élevée correspond à la deuxième zone dopée 43. On verra, dans la description faisant référence à la figure 6, qu'il s'agit en effet d'une configuration pouvant être réalisée de façon particulièrement aisée.

On réalise ainsi une matrice 4 de photodiodes dans laquelle l'impact des défauts liés à la gravure des mésas est minimisé et donc pour laquelle le courant d'obscurité est minimisé.

On pourrait observer qu'il suffirait d'augmenter la concentration en cadmium dans toute la couche utile 40, pour obtenir ce même effet. Néanmoins, la longueur d'onde du rayonnement détecté serait modifiée et il ne serait par exemple plus possible de détecter de très grandes longueurs d'onde, notamment dans l'infrarouge dit LWIR ou VLWIR.

En effet, une photodiode ne permet de détecter que des longueurs d'onde dont l'énergie correspond sensiblement au gap du matériau de la zone de détection, située dans la base 45 de la couche utile. Un faible gap correspond à la détection d'un rayonnement de grande longueur d'onde, et inversement. On conserve donc un faible gap dans la base 45, en particulier dans la première région dopée 44A, afin de pouvoir détecter de grandes longueurs d'onde. On réalise ainsi une matrice 4 de photodiodes présentant un courant d'obscurité réduit, et permettant de détecter de grandes longueurs d'ondes, par exemple des longueurs d'onde MWIR ou LWIR.

Par exemple, la première zone dopée 44 s'étend dans la base 45, dans une partie inférieure des plots et au centre des plots. Les deuxièmes zones dopées 43 s'étendent par exemple à partir de la paroi supérieure 49 et des parois latérales 48, sur une épaisseur de couche utile comprise entre 1 µm et 2 µm. Les deuxièmes zones dopées 43 présentent une concentration en cadmium correspondant par exemple à x=0,3 ou x=0,5 dans du CdₓHg₁₋ₓTe. A l'interface avec la première zone dopée 44, la concentration en cadmium diminue brutalement pour rejoindre une concentration définie par x=0,22.

Pour chaque photodiode, la zone de charge d'espace s'étend autour de la jonction PN, sur une partie de la deuxième zone dopée 43 et une partie de la première zone dopée 44.

Des deuxièmes zones dopées 43, dopées P, peuvent être obtenues par dopage à l'arsenic. Elles présentent typiquement une densité de porteurs majoritaires de l'ordre de 10¹⁸ atomes/cm³. La première zone dopée 44, dopée N, présente quant à elle, dans sa première région 44A, une densité de porteurs majoritaires typiquement de l'ordre de 8.10¹⁵ atomes/cm³. La zone de charge d'espace de chaque photodiode s'étend préférentiellement du côté le moins dopé, donc du côté de la première zone dopée 44. Néanmoins, le gap dans la deuxième zone dopée 43 est suffisamment élevé par rapport au gap dans la première zone dopée 44, pour que l'on obtienne tout de même un gap moyen dans la zone de charge d'espace supérieur au gap dans la première zone dopée 44.

Ainsi, le mode de réalisation illustré en figure 4 permet en outre d'augmenter le gap moyen dans les zones de charge d'espace, tout en permettant la détection de grandes longueurs d'ondes, par exemple des longueurs d'onde MWIR ou LWIR.

L'augmentation du gap moyen dans les zones de charge d'espace permet d'y limiter la création spontanée de porteurs minoritaires par phénomène de génération-recombinaison. Ainsi, l'augmentation du gap moyen dans les zones de charge d'espace contribue également à réduire le courant d'obscurité de la matrice de photodiodes selon l'invention.

On remarque que la différence de gap entre une deuxième zone dopée 43 et la première zone dopée 44, due à la différence de concentration en cadmium, n'est pas suffisante pour créer une barrière de potentiel qui empêcherait les porteurs minoritaires formés dans la base 45 d'atteindre la jonction PN. Cet effet est atteint sans qu'il soit nécessaire de prendre des précautions particulières.

On va maintenant décrire un exemple de procédé de fabrication d'une matrice de photodiodes selon l'invention.

Dans une étape 500, on grave une couche utile 50 en CdₓHg₁₋ₓTe, pour former des plots 52 dits mésa. La gravure conserve une épaisseur de couche utile nommée « base » 55, qui forme un socle commun pour les plots 52. A chaque plot correspondra une photodiode, une photodiode étant définie par une jonction PN, et éventuellement des connecteurs métalliques pour polariser cette jonction. L'étape 500 est une étape classique de gravure d'une photodiode mésa, et ne sera donc pas décrite plus avant. Cette gravure peut être une gravure humide ou une gravure sèche.

Au cours d'une étape 501, on réalise une jonction PN sur chacun des plots 52. Cette jonction PN correspond à une interface entre une première zone 54 dopée N ou P, et une deuxième zone 53 dopée P ou N.

On peut prévoir de réaliser cette jonction selon l'une des nombreuses techniques connues.

Par exemple, on réalise des deuxièmes zones 53 dopées P au sein d'un matériau dopé N, par implantation ionique d'un dopant P (dopant accepteur) dans la couche utile 50. Par exemple, on implante de l'arsenic, avec une énergie d'implantation de 300 keV et une dose de 8.10¹⁵ atomes/cm². On réalise ensuite un recuit adapté à environ 400°C pour activer le dopant P. Ce recuit crée des lacunes de mercure dans toute la couche utile 50. On obtient donc une deuxième zone 53 fortement dopée P (grâce à l'implantation d'arsenic) et une première zone 54 faiblement dopée P (à cause des lacunes de mercure). On réalise ensuite un recuit adapté à environ 220°C pour combler les lacunes de mercure. La première zone 54 faiblement dopée P devient dopée N.

En variante, on pourra réaliser une deuxième zone 53 fortement dopée N dans un matériau dopé P. Pour cela, on réalise un recuit pour ajuster le niveau de lacunes de mercure, de façon à doper P la couche. Ensuite, on implante un élément dopant N dans la couche utile 50, par exemple du bore de l'indium ou autre, pour former les deuxièmes zones dopées 53.

On pourra également prévoir de mettre en oeuvre l'étape 500 après l'étape 501 de création d'une jonction PN. Dans ce cas, la création d'au moins une jonction PN met en oeuvre un simple dépôt de deux couches de natures différentes. Par exemple, on dépose au-dessus d'une couche en CdₓHg₁₋ₓTe une couche supérieure en CdₓHg₁₋ₓTe contenant en outre des atomes d'arsenic, de façon à obtenir au final une couche dopée N surmontée d'une couche dopée P formant ensemble la couche utile. La gravure ultérieure 500 permet de séparer des plots 52 présentant chacun une jonction PN (voir figure 2).

Selon l'invention, le procédé de fabrication d'une matrice de photodiodes comprend en outre une étape 502 de sur-dopage de régions 54B situées entre deux plots 52 voisins.

Cette étape est mise en oeuvre après l'étape 500 et avant ou après l'étape 501.

Cette étape 502 met en oeuvre une implantation ionique entre deux plots 52 de façon à former, dans la première zone dopée 54 :
- au moins une première région 54A présentant une première densité de dopage, et située au moins sous chacun desdits plots ; et
- au moins une deuxième région 54B, situées entre deux plots voisins, et présentant une deuxième densité de dopage, supérieure à la première densité de dopage.

Selon un premier exemple, on part d'une première zone dopée 54, dopée N avec une densité de dopage de 8.10¹⁵ atomes/cm³. On réalise ensuite une deuxième région 54B par implantation d'atomes d'indium ou de bore ou autre dans cette première zone dopée 54. Cette implantation ionique augmente localement la densité de dopage dans la première zone dopée 54, divisant celle-ci en une deuxième région 54B et une première région 54A.

Dans le cas du bore, on utilise une énergie d'implantation de 300 keV et avec une dose de 5.10¹⁴ atomes/cm². L'énergie d'implantation détermine une profondeur d'implantation des atomes de bore dans la couche utile.

Les atomes de bore diffusent de façon quasi-isotrope dans la couche utile à partir de leur point d'implantation (diffusion préférentiellement en profondeur dans la couche utile). On peut donc contrôler la taille de chaque deuxième région 54B en contrôlant l'énergie d'implantation et la densité de dopage mises en oeuvre lors de cette étape 502. Par exemple, on peut faire en sorte qu'une deuxième région 54B s'étende ou non jusqu'à la face inférieure 56B, et/ou qu'elle s'étende ou non sous une portion des parois latérales 58. On effectue une implantation de telle sorte que la diffusion quasi-isotrope des atomes forme des passages en forme d'entonnoir pour les porteurs minoritaires, dans la première région 54A et entre des régions 54B. Ces passages guident alors un porteur minoritaire vers la jonction PN au regard de laquelle ce porteur minoritaire s'est formé.

Selon un deuxième exemple, on part d'une première zone dopée 54, dopée P avec une densité de dopage de 10¹⁶ atomes/cm³. On réalise ensuite une deuxième région 54B par implantation d'atomes d'arsenic dans cette première zone dopée 54. Cette implantation ionique permet d'augmenter localement la densité de dopage dans la première zone dopée 54, divisant celle-ci en une deuxième région 54B et une première région 54A.

Les atomes d'arsenic sont implantés avec une énergie de 300 keV et avec une dose de 8. 10¹⁵ atomes/cm², pour former une deuxième région 54B dans la première zone dopée 54. Suite à cette implantation il est nécessaire de faire un recuit adapté autour de 400 °C pour obtenir un dopage de type P. L'énergie d'implantation et la diffusion liée au recuit déterminent une profondeur d'implantation des atomes d'arsenic dans la couche utile. Les atomes d'arsenic diffusent de façon quasi-isotrope dans la couche utile à partir de leur point d'implantation. On peut donc contrôler la taille de la deuxième région 54B en contrôlant l'énergie d'implantation et la densité de dopage mises en oeuvre lors de cette étape 502. Par exemple, on peut faire en sorte qu'une deuxième région 54B s'étende ou non jusqu'à la face inférieure 56B, et/ou qu'elle s'étende ou non sous une portion des parois latérales 58.

On pourra ensuite réaliser des étapes classiques d'installation d'au moins un élément de contact électrique au contact de la couche utile. Cet élément de contact électrique permet de polariser électriquement la photodiode.

L'étape 502 d'implantation ionique est mise en oeuvre depuis la surface de la couche utile située entre les plots 52.

On réalise ainsi, avec une énergie d'implantation modérée, une barrière de potentiel s'étendant dans la couche utile (considérée en particulier à partir de la paroi supérieure 59 des plots).

La distance de diffusion dans la couche utile des éléments dopants injectés est liée à leur énergie d'implantation. Selon l'invention, on utilise des énergies d'implantation réduites, ce qui correspond à une distance de diffusion réduite des éléments dopants après avoir été injectés. Il est avantageux de recourir à une distance de diffusion réduite, (liée en pratique à des énergies d'implantation de l'ordre de 100-400 keV), car cette diffusion est également latérale (diffusion quasi-isotrope, et non entièrement isotrope). Si la longueur de diffusion était trop grande comparée au pas de la matrice de photodiodes, l'étendue latérale des deuxièmes régions 54B ainsi obtenues gênerait l'accès des porteurs minoritaires à une jonction PN, voire l'empêcherait. On obtiendrait alors des photodiodes présentant des efficacités quantiques médiocres.

Pour cette raison, l'énergie d'implantation ne peut pas être très élevée et on ne peut obtenir une FTM de bonne qualité qu'en la combinant avec une structure Mésa.

Le procédé selon l'invention permet ainsi de réaliser de façon économe en énergie, simple et astucieuse, une matrice de photodiodes selon l'invention.

La figure 6 illustre plus particulièrement un procédé selon l'invention de fabrication d'une matrice de photodiode telle qu'illustrée en figure 4.

L'étape 600 correspond à l'étape 500 tel que décrite en référence à la figure 5. Les références numériques 50, 51, 52, 55 correspondent respectivement aux références numériques 60, 61, 62, 65.

Dans une deuxième étape 601, on réalise une jonction PN sur chacun des plots 62. Cette jonction PN correspond à une interface entre une première zone 64 dopée N, et une deuxième zone 63 dopée P. Comme décrit en référence à la figure 5, on obtient de telles zones dopées par implantation d'un dopant P tel que de l'arsenic. Pour chaque plot 62, l'implantation ionique est réalisée à partir des parois latérales 68 et de la paroi supérieure 69, de manière à réaliser une deuxième zone 63 dopée P et localisée sous lesdites parois latérales 68 et paroi supérieure 69. Le centre de chaque plot est dopé N, et correspond à la première zone dopée 64. De même, la première zone dopée 64 s'étend entre les plots et depuis la face supérieure de la couche active.

Au cours d'une troisième étape 602, on dépose sur le dessus de la couche utile 60 une couche de réservoir 630 riche en cadmium. La couche de réservoir 630 est réalisée en un matériau binaire, ternaire, ou quaternaire, voire plus. Ce matériau comprend avantageusement des éléments appartenant aux colonnes II et VI du tableau périodique des éléments. Il s'agit par exemple et de manière non limitative de CdS, CdSe, CdTe, CdZnSe, CdMnSSe, etc.

La couche de réservoir 630 présente une épaisseur de plusieurs milliers d'angströms, par exemple 1 µm

Le dépôt de la couche de réservoir 630 est effectué par toute technique connue de dépôt de couche mince.

Le cas échéant, on peut prévoir une étape (non représentée) de suppression de la partie de couche de réservoir 630 située entre les plots, au contact de la première zone dopée 64. On ne conserve alors que la partie de couche de réservoir 630 située au contact de la deuxième zone dopée 63. Une telle étape peut mettre en oeuvre un dépôt d'une couche de résine, gravure de la couche de résine par lithographie, gravure de la couche de réservoir au travers des ouvertures réalisées dans la couche de résine, et suppression de la couche de résine. La gravure de la couche de réservoir est avantageusement une gravure chimique. Néanmoins, on préfère en pratique conserver intacte la couche de réservoir 630.

Lors de l'étape 603, on réalise un recuit adapté de l'ensemble formé par la couche utile 60 et la couche de réservoir 630 (ayant éventuellement été gravée). Ce recuit sera par exemple effectué à une température comprise entre 100°C et 500°C, de préférence entre 300°C et 500°C, et pendant une durée pouvant aller de quelques minutes à plusieurs heures. Par exemple, le recuit correspond à un chauffage à 430 °C, pendant 50 h.

Au cours de ce recuit, les atomes de cadmium de la couche de réservoir 630 vont diffuser vers les deuxièmes zones dopées 63.

Les atomes de cadmium diffusent très préférentiellement dans une zone fortement dopée P, et le gap dépend de la concentration en cadmium, c'est pourquoi le recuit de diffusion forme finalement une ouverture de gap localisé dans les deuxièmes zones dopées 63. En d'autres termes, les deuxièmes zones dopées 63 présenteront ainsi une valeur moyenne de bande interdite supérieure à celle de première région 64A. On peut relever que la densité de dopage P obtenue dans les deuxièmes zones dopées 63 est en pratique de l'ordre de 10¹⁸ atomes/cm³. Pour de telles valeurs, le gradient de gap réalisé entre les deuxièmes zones dopées 63 et la première zone dopée 64 (en particulier les premières régions 64A) n'empêche pas les porteurs minoritaires d'atteindre la jonction PN.

Lors d'une étape 604, on forme les régions sur-dopées 64B, par implantation ionique d'un dopant N tel que du bore ou de l'indium ou autre. Selon les cas, on peut supprimer ou conserver tout ou partie de la couche correspondant, après recuit, à la couche de réservoir 630. L'implantation de bore peut se faire au travers de cette couche, c'est pourquoi il n'est pas nécessaire de la supprimer pour réaliser les deuxièmes régions 64B. On préfère même la conserver.

Selon une variante de ce procédé, un unique recuit réalise à la fois la diffusion du cadmium et l'activation du dopant P.

La figure 7 illustre un autre exemple de procédé selon l'invention.

Les références numériques 50, 51, 52, 53, 54, 54A, 54B correspondent respectivement aux références numériques 70, 71, 72, 73, 74A, 74B.

L'étape 700 correspond à l'étape 500 tel que décrite en référence à la figure 5.

Lors d'une étape 701, on forme les régions sur-dopées 74B, par implantation ionique, entre les plots 72, d'un élément dopant accepteur tel que de l'arsenic. Après recuit d'activation du dopant P, on obtient ainsi des deuxièmes régions 74B sur-dopées P, le reste de la couche utile étant dopé P.

Au cours d'une deuxième étape 702, on dépose sur le dessus de la couche utile 70 une couche de réservoir 730 riche en cadmium. Les détails de réalisation concernant cette étape 702 et la couche de réservoir 730 correspondent à ce qui est détaillé ci-dessus en référence à la figure 6 et à propos de l'étape 602 et de la couche de réservoir 630.

Le procédé comprend avantageusement une étape, de structuration de la couche de réservoir 730. Il s'agit de supprimer une partie de la couche de réservoir 730 située sur les plots, notamment au-dessus de la région de couche utile qui n'est pas sur-dopée P (ou qui n'est pas destinée à le devenir après un recuit d'activation d'un dopant P). Une telle étape peut mettre en oeuvre un dépôt d'une couche de résine, gravure de la couche de résine par lithographie, gravure de la couche de réservoir au travers des ouvertures réalisées dans la couche de résine, et suppression de la couche de résine. La gravure de la couche de réservoir est avantageusement une gravure chimique à l'aide d'une solution de brome.

Lors de l'étape 703, on réalise un recuit de l'ensemble formé par la couche utile 70 et la couche de réservoir 730 (ayant éventuellement été structurée comme illustré en figure 7). Ce recuit sera par exemple effectué à une température comprise entre 100°C et 500°C, de préférence entre 300°C et 500°C, et pendant une durée pouvant aller de quelques minutes à plusieurs heures. Par exemple, le recuit correspond à un chauffage à 430 °C, pendant 50 h.

Au cours de ce recuit, les atomes de cadmium de la couche de réservoir 730 vont diffuser vers les deuxièmes régions 74B. On peut donc parler d'un recuit de diffusion. Comme précisé ci-avant en référence à la figure 6, les atomes de cadmium diffusent très préférentiellement dans une zone fortement dopée P, c'est pourquoi le recuit de diffusion forme finalement un caisson de cadmium localisé ici dans les deuxièmes régions 74B.

Selon une variante de ce procédé, un unique recuit réalise à la fois la diffusion, et l'activation du dopant P.

On obtient ainsi des deuxièmes régions 74B sur-dopées, et présentant une forte concentration en cadmium.

Lors de l'étape 704, on réalise une implantation ionique d'un dopant N (dopant donneur) tel que du bore ou de l'indium ou autre, de façon à former dans chaque plot une jonction PN entre une deuxième zone dopée N 73, et la première zone dopée P. La première zone dopée P se compose des deuxièmes régions 74B sur-dopées, le reste de cette première zone formant la première région 74B.

## Revendications

1. Matrice (2 ; 3 ; 4) d'au moins deux photodiodes comprenant une couche utile (20; 30 ; 40; 50; 60; 70) consistant en un alliage semi-conducteur de cadmium, mercure et tellure de type CdₓHg₁₋ₓTe, la couche utile présentant :
- une base (25 ; 35 ; 45 ; 55; 65), située du côté d'une face inférieure (26B ; 36B; 46B; 56B) de la couche utile ; et
- des plots (22 ; 32 ; 42 ; 52 ; 62 ; 72), situés du côté d'une face supérieure (26A ; 36A ; 46B) de la couche utile ;
la base formant un socle commun pour les plots, et chaque plot correspondant à une photodiode, la couche utile comprenant :
- une première zone dopée (24 ; 34 ; 44 ; 54 ; 64) présentant un premier dopage N ou P, s'étendant au moins dans ladite base ; et
- pour chaque plot (22 ; 32 ; 42 ; 52 ; 62 ; 72), une deuxième zone dopée (23 ; 33 ; 43 ; 53 ; 63 ; 73) présentant un deuxième dopage P ou N de nature différente de celle du premier dopage, s'étendant au moins sur une région supérieure dudit plot, du côté du plot opposé à la base ;
dans laquelle la première zone dopée (24 ; 34 ; 44 ; 54 ; 64) comprend :
- au moins une première région (24A ; 34A ; 44A ; 54A ; 64A ; 74A) présentant une première densité de dopage, située au moins sous chacun desdits plots; et
- au moins une deuxième région (24B ; 34B ; 44B ; 54B ; 64B ; 74B), située entre deux plots voisins, et présentant une deuxième densité de dopage supérieure à la première densité de dopage, chaque deuxième région (24B ; 34B ; 44B ; 54B ; 64B ; 74B) étant séparée de la deuxième zone dopée (23 ; 33 ; 43 ; 53 ; 63 ; 73) la plus proche par au moins une portion de la première région (24A ; 34A ; 44A ; 54A ; 64A ; 74A) ;
**caractérisée en ce que** la largeur de la deuxième région (24B ; 34B; 44B ; 54B ; 64B; 74B) diminue au fur et à mesure que l'on se rapproche de la face inférieure (26B ; 36B ; 46B; 56B) de la couche utile.

2. Matrice (3) selon la revendication 1, **caractérisée en ce qu'**au moins une deuxième région (34B) s'étend depuis une face supérieure (36A) de la couche utile, jusqu'à une face inférieure (36B) de la couche utile, du côté opposé aux plots.

3. Matrice (2 ; 3 ; 4) selon la revendication 1 ou 2, **caractérisée en ce qu'**au moins une deuxième région (24B ; 34B ; 44B ; 54B ; 64B ; 74B) s'étend entre deux plots (22 ; 32 ; 42 ; 52 ; 62 ; 72) voisins et sur au moins une portion des surfaces latérales (28 ; 38 ; 48 ; 58; 68) desdits deux plots voisins.

4. Matrice (2 ; 3 ; 4) selon l'une quelconque des revendications 1 à 3, **caractérisée en ce que** la deuxième densité de dopage est au moins deux fois supérieure à la première densité de dopage.

5. Matrice (2 ; 3 ; 4) selon l'une quelconque des revendications 1 à 4, **caractérisée en ce que** la deuxième densité de dopage est au moins dix fois supérieure à la première densité de dopage.

6. Matrice (2; 3; 4) selon l'une quelconque des revendications 1 à 5, **caractérisée en ce que** la première zone dopée (24; 34; 44 ; 54; 64) est dopée N et les deuxièmes zones dopées (23 ; 33 ; 43 ; 53 ; 63 ; 73) sont dopées P.

7. Matrice (4) selon la revendication 6, **caractérisée en ce que** chaque deuxième zone dopée (43 ; 63) s'étend en outre sur les parois latérales (48 ; 68) d'un plot, et présente une concentration en cadmium supérieure à la concentration en cadmium dans la première zone dopée (44 ; 64).

8. Matrice (4) selon l'une la revendication 7, **caractérisée en ce que** la couche utile est recouverte, du côté des plots, par une couche (630) présentant une concentration en cadmium supérieure à celle de la couche utile.

9. Matrice (2 ; 3 ; 4) selon l'une quelconque des revendications 1 à 8, **caractérisée en ce que** la première zone dopée (24; 34; 44; 54; 64) est dopée P et les deuxièmes zones dopées (23 ; 33 ; 43; 53; 63; 73) sont dopées N, et l'au moins une deuxième région (24B; 34B; 44B; 54B; 64B; 74B) présente une concentration en cadmium supérieure à la concentration en cadmium dans la première région (24A ; 34A; 44A; 54A; 64A; 74A).

10. Procédé de fabrication d'une matrice d'au moins deux photodiodes selon l'une quelconque des revendications précédentes, comprenant les étapes suivantes :
- gravure (500 ; 600, 700), dans la couche utile (50 ; 60 ; 70) consistant en un alliage semi-conducteur de cadmium, mercure et tellure de type CdₓHg₁₋ₓTe, d'au moins deux plots (52 ; 62 ; 72) associés chacun à une photodiode, la gravure conservant une épaisseur de la couche utile, dite la base (55; 65), formant le socle commun pour les plots;
- création (501 ; 601; 704) d'au moins une jonction PN, de sorte que la couche utile présente :
- la première zone dopée (54 ; 64) présentant un premier dopage N ou P, s'étendant au moins dans ladite base ; et
- pour chaque plot (52 ; 62 ; 72), la deuxième zone dopée (53 ; 63 ; 73) présentant un deuxième dopage P ou N de nature différente de celle du premier dopage, s'étendant au moins sur la région supérieure dudit plot, du côté du plot opposé à la base ;
le procédé comprenant une étape supplémentaire de dopage (502 ; 604; 701) réalisée de façon à former :
- au moins une première région (54A; 64A; 74A) présentant une première densité de dopage, située au moins sous chacun desdits plots (52 ; 62 ; 72) ; et
- au moins une deuxième région (54B ; 64B ; 74B) située entre deux plots voisins, et présentant une deuxième densité de dopage, supérieure à la première densité de dopage, chaque deuxième région (54B; 64B ; 74B) étant séparée de la deuxième zone dopée (53; 63; 73) la plus proche par au moins une portion de la première région (54A ; 64A ; 74A),
le procédé étant **caractérisé en ce que** l'étape supplémentaire de dopage est réalisée par implantation ionique entre deux plots,
et **en ce que** la largeur de la deuxième région diminue au fur et à mesure que l'on se rapproche de la face inférieure de la couche utile.

11. Procédé selon la revendication 10, **caractérisé en ce que** l'étape (704) de création d'au moins une jonction PN met en oeuvre une implantation ionique d'un dopant donneur, **en ce que** l'étape supplémentaire de dopage (701) met en oeuvre une implantation ionique d'un dopant accepteur, et **en ce qu'**il comprend en outre les étapes suivantes :
- dépôt (702), sur la couche utile, d'une couche, dite couche de réservoir (730), présentant une concentration en cadmium supérieure à celle de la couche utile (70) ;
- recuit (703) de la couche utile (70) recouverte de la couche de réservoir (730) réalisant une diffusion des atomes de cadmium de la couche de réservoir, depuis la couche de réservoir vers la couche utile.

12. Procédé selon la revendication 11, **caractérisé par** une étape de gravure d'une portion de la couche de réservoir (730) située au-dessus des plots (72), cette étape étant réalisée avant le recuit (703).

13. Procédé selon la revendication 10, **caractérisé en ce que** l'étape (601) de création d'au moins une jonction PN met en oeuvre une implantation ionique d'un dopant accepteur sur les parois latérales (68) et la paroi supérieure (69) de chaque plot (62), et **en ce qu'**il comprend en outre les étapes suivantes :
- dépôt (602), sur la couche utile, d'une couche, dite couche de réservoir (630), présentant une concentration en cadmium supérieure à celle de la couche utile (60) ;
- recuit (603) de la couche utile (60) recouverte de la couche de réservoir (630) réalisant une diffusion des atomes de cadmium de la couche de réservoir, depuis la couche de réservoir vers la couche utile.

## Patentansprüche

1. Matrix (2; 3; 4) von zumindest zwei Photodioden mit einer Nutzschicht (20; 30; 40; 50; 60; 70), die aus einer Halbleiterlegierung aus Cadmium, Quecksilber und Tellur vom Typ CdₓHg₁₋ₓTe besteht, wobei die Nutzschicht aufweist:
- eine Basis (25; 35; 45; 55; 65), die auf der Seite einer Unterseite (26B; 36B, 46B, 56B) der Nutzschicht liegt; und
- Kissen (22; 32; 42; 52; 62; 72), die auf der Seite einer Oberseite (26A; 36A; 46B) der Nutzschicht liegen;
wobei die Basis einen gemeinsamen Sockel für die Kissen bildet, wobei jedes Kissen einer Photodiode entspricht, wobei die Nutzschicht enthält:
- eine erste dotierte Zone (24; 34; 44; 54; 64) mit einer erste n- oder p-Dotierung, die sich zumindest in der Basis erstreckt; und
- für jedes Kissen (22; 32; 42; 52; 62; 72) eine zweite dotierte Zone (23; 33; 43; 53; 63; 73), die eine zweite p- oder n-Dotierung aufweist, vom Typ verschieden von dem Typ der ersten Dotierung, und die sich zumindest über einen oberen Bereich des Kissen auf der der Basis entgegengesetzten Seite des Kissen erstreckt;
wobei die erste dotierte Zone (24; 34; 44; 54; 64) enthält:
- zumindest einen ersten Bereich (24A; 34A; 44A; 54A; 64A; 74A) mit einer ersten Dotierungsdichte, die sich zumindest unter jedem der Kissen befindet; und
- zumindest einen zweiten Bereich (24B; 34B; 44B; 54B; 64B; 74B), der sich zwischen zwei benachbarten Kissen befindet und eine zweite Dotierungsdichte aufweist, die höher ist als die erste Dotierungsdichte, wobei jeder zweite Bereich (24B; 34B; 44B; 54B; 64B; 74B) durch zumindest einen Teil des ersten Bereichs (24A; 34A; 44A; 54A; 64A; 74A) von der nächstliegenden zweiten dotierten Zone (23; 33; 43; 53; 63; 73) getrennt ist;
**dadurch gekennzeichnet, dass** die Breite des zweiten Bereichs (24B; 34B; 44B; 54B; 64B; 74B) mit Annäherung an die Unterseite (26B; 36B; 46B; 56B) der Nutzschicht immer mehr abnimmt.

2. Matrix (3) nach Anspruch 1, **dadurch gekennzeichnet, dass** zumindest ein zweiter Bereich (34B) sich von einer Oberseite (36A) der Nutzschicht bis zu einer Unterseite (36B) der Nutzsicht auf der den Kissen entgegengesetzten Seite erstreckt.

3. Matrix (2; 3; 4) nach Anspruch 1 oder 2, **dadurch gekennzeichnet, dass** zumindest ein zweiter Bereich (24B; 34B; 44B; 54B; 64B; 74B) sich zwischen zwei benachbarten Kissen (22; 32; 42; 52; 62; 72) und über zumindest einen Teil der Seitenflächen (28; 38; 48; 58; 68) der beiden benachbarten Kissen erstreckt.

4. Matrix (2; 3; 4) nach einem der Ansprüche 1 bis 3, **dadurch gekennzeichnet, dass** die zweite Dotierungsdichte zumindest zwei Mal so hoch ist wie die erste Dotierungsdichte.

5. Matrix (2; 3; 4) nach einem der Ansprüche 1 bis 4, **dadurch gekennzeichnet, dass** die zweite Dotierungsdichte zumindest zehn Mal so hoch ist wie die erste Dotierungsdichte.

6. Matrix (2; 3; 4) nach einem der Ansprüche 1 bis 5, **dadurch gekennzeichnet, dass** die erste dotierte Zone (24; 34; 44; 54; 64) n-dotiert ist und die zweiten dotierten Zonen (23; 33; 43; 53; 63; 73) p-dotiert sind.

7. Matrix (4) nach Anspruch 6, **dadurch gekennzeichnet, dass** jede zweite dotierte Zone (43; 63) sich ferner über die Seitenwände (48; 68) eines Kissen erstreckt und eine Cadmiumkonzentration aufweist, die höher ist als die Cadmiumkonzentration in der ersten dotierten Zone (44; 64).

8. Matrix (4) nach Anspruch 7, **dadurch gekennzeichnet, dass** die Nutzschicht auf der Seite der Kissen mit einer Schicht (630) überzogen ist, die eine Cadmiumkonzentration aufweist, die höher als die der Nutzschicht ist.

9. Matrix (2; 3; 4) nach einem der Ansprüche 1 bis 8, **dadurch gekennzeichnet, dass** die erste dotierte Zone (24; 34; 44; 54; 64) p-dotiert ist und die zweiten dotierten Zonen (23; 33; 43; 53; 63; 73) n-dotiert sind, und der zumindest eine zweite Bereich (24B; 34B; 44B; 54B; 64B; 74B) eine Cadmiumkonzentration aufweist, die höher ist als die Cadmiumkonzentration in dem ersten Bereich (24A; 34A; 44A; 54A; 64A; 74A).

10. Verfahren zum Herstellen einer Matrix von zumindest zwei Photodioden nach einem der vorangehenden Ansprüche, umfassend die nachfolgenden Schritte:
- Ätzen (500; 600, 700) von zumindest zwei Kissen (52; 62; 72), die jeweils einer Photodiode zugeordnet sind, in die Nutzschicht (50; 60; 70), die aus einer Halbleiterlegierung aus Cadmium, Quecksilber und Tellur vom Typ CdₓHg₁₋ₓTe besteht, wobei das Ätzen eine Dicke der Nutzschicht aufrecht erhält, Basis (55; 65) genannt, die den gemeinsamen Sockel für die Kissen bildet;
- Erzeugen (501; 601; 704) von zumindest einem pn-Übergang, so dass die Nutzschicht aufweist:
- die erste dotierte Zone (54; 64) mit einer ersten n- oder p-Dotierung, die sich zumindest in der Basis erstreckt; und
- für jedes Kissen (52; 62; 72), die zweite dotierte Zone (53; 63; 73), die eine zweite p- oder n-Dotierung aufweist, vom Typ der sich von der der ersten Dotierung unterscheidet, und sich zumindest über den oberen Bereich des Kissen auf der der Basis entgegengesetzten Seite des Kissen erstreckt;
wobei das Verfahren umfasst:
einen zusätzlichen Dotierungsschritt (502; 604; 701), der so erfolgt, dass entsteht:
- zumindest ein erster Bereich (54A; 64A; 74A) mit einer ersten Dotierungsdichte, der sich zumindest unter jedem der Kissen (52; 62; 72) befindet; und
- zumindest ein zweiter Bereich (54B; 64B; 74B), der sich zwischen zwei benachbarten Kissen befindet und eine zweite Dotierungsdichte aufweist, die höher ist als die erste Dotierungsdichte, wobei jeder zweite Bereich (54B; 64B; 74B) durch zumindest einen Teil des ersten Bereichs (54A; 64A; 74A) von der nächstliegenden zweiten dotierten Zone (53; 63; 73) getrennt ist,
wobei das Verfahren **dadurch gekennzeichnet ist, dass** der zusätzliche Dotierungsschritt durch Ionenimplantation zwischen zwei Kissen erfolgt,
und dass die Breite des zweiten Bereichs mit Annäherung an die Unterseite der Nutzschicht immer mehr abnimmt.

11. Verfahren nach Anspruch 10, wobei der Schritt (704) des Erzeugens zumindest eines pn-Übergangs eine Ionenimplantation eines Donator-Dotierstoffs umfasst, dass der zusätzliche Dotierungsschritt (701) eine Ionenimplantation eines Akzeptor-Dotierstoffs umfasst und dass es ferner die nachfolgenden Schritte umfasst:
- Aufbringen (702), auf die Nutzschicht, einer Schicht, Reservoirschicht (730) genannt, mit einer Cadmiumkonzentration höher als die der Nutzschicht (70);
- Glühen (703) der mit der Reservoirschicht (730) überzogenen Nutzschicht (70), wodurch eine Diffusion der Cadmiumatome der Reservoirschicht von der Reservoirschicht zur Nutzschicht erfolgt.

12. Verfahren nach Anspruch 11, **gekennzeichnet durch** einen Schritt des Ätzens eines Teils der Reservoirschicht (730), der über den Kissen (72) liegt, wobei dieser Schritt vor dem Glühen (703) erfolgt.

13. Verfahren nach Anspruch 10, **dadurch gekennzeichnet, dass** bei dem Schritt (601) des Erzeugens von zumindest einem pn-Übergang eine Ionenimplantation eines Akzeptor-Dotierstoffs an den Seitenwänden (68) und der oberen Wand (69) eines jeden Kissen (62) erfolgt, und dass es ferner die nachfolgenden Schritte umfasst:
- Aufbringen (602), auf die Nutzschicht, einer Schicht, Reservoirschicht (630) genannt, mit einer Cadmiumkonzentration höher als die der Nutzschicht (60);
- Glühen (703) der mit der Reservoirschicht (630) überzogenen Nutzschicht (60), wodurch eine Diffusion der Cadmiumatome der Reservoirschicht von der Reservoirschicht zur Nutzschicht erfolgt.

## Claims

1. An array (2; 3; 4) of at least two photodiodes including a useful layer (20; 30; 40; 50; 60; 70) consisting of a CdₓHg₁₋ₓTe type cadmium mercury and tellurium semi-conductor alloy, the useful layer having:
- a base (25; 35; 45; 55; 65), located on the side of a lower face (26B; 36B; 46B; 56B) of the useful layer; and
- pads (22; 32; 42; 52; 62; 72), located on the side of an upper face (26A; 36A; 46A) of the useful layer;
the base forming a common stand for the pads, and each pad corresponding to a photodiode, the useful layer comprising:
- a first doped zone (24; 34; 44; 54; 64) having a first N or P doping, extending at least in said base; and
- for each pad (22; 32; 42; 52; 62; 72), a second doped zone (23; 33; 43; 53; 63; 73) having a second P or N doping of a different type from that of the first doping, extending at least in an upper region of said pad, on the side of the pad opposite to the base;
wherein the first doped zone (24; 34; 44; 54; 64) comprises:
- at least one first region (24A; 34A; 44A; 54A; 64A; 74A) having a first doping density, located at least under each of said pads; and
- at least one second region (24B; 34B; 44B; 54B; 64B; 74B), located between two neighboring pads, and having a second doping density higher than the first doping density, each second region (24B; 34B; 44B; 54B; 64B; 74B) being separated from the closest second doped zone (23; 33; 43; 53; 63; 73) by at least one portion of the first region (24A; 34A; 44A; 54A; 64A; 74A);
**characterized in that** the width of the second region (24B; 34B; 44B; 54B; 64B; 74B) decreases when the distance to the lower face (26B; 36B; 46B; 56B) of the useful layer decreases.

2. The array (3) according to claim 1, **characterized in that** at least one second region (34B) extends from an upper face (36A) of the useful layer, to a lower face (36B) of the useful layer, on the side opposite to the pads.

3. The array (2; 3; 4) according to claim 1 or 2, **characterized in that** at least one second region (24B; 34B; 44B; 54B; 64B; 74B) extends between two neighboring pads (22; 32; 42; 52; 62; 72) and on at least one portion of the side surfaces (28; 38; 48; 58; 68) of said two neighboring pads.

4. The array (2; 3; 4) according to any of claims 1 to 3, **characterized in that** the second doping density is at least twice higher than the first doping density.

5. The array (2; 3; 4) according to any of claims 1 to 4, **characterized in that** the second doping density is at least ten times higher than the first doping density.

6. The array (2; 3; 4) according to any of claims 1 to 5, **characterized in that** the first doped zone (24; 34; 44; 54; 64) is N doped and the second doped zones (23; 33; 43; 53; 63; 73) are P doped.

7. The array (4) according to claim 6, **characterized in that** each second doped zone (43; 63) further extends on the side walls (48; 68) of a pad, and has a cadmium concentration higher than the cadmium concentration in the first doped zone (44; 64).

8. The array (4) according to claim 7, **characterized in that** the useful layer is covered, on the side of the pads, with a layer (630) having a cadmium concentration higher than that of the useful layer.

9. The array (2; 3; 4) according to any of claims 1 to 8, **characterized in that** the first doped zone (24; 34; 44; 54; 64) is P doped and the second doped zones (23; 33; 43; 53; 63; 73) are N doped, and the at least one second region (24B; 34B; 44B; 54B; 64B; 74B) has a cadmium concentration higher than the cadmium concentration in the first region (24A; 34A; 44A; 54A; 64A; 74A).

10. A method for manufacturing an array of at least two photodiodes according to any of the preceding claims, comprising the following steps of:
- etching (500; 600, 700), in the useful layer (50; 60; 70) consisting of a CdₓHg₁₋ₓTe type cadmium mercury and tellurium semi-conductor alloy, at least two pads (52; 62; 72) each associated with a photodiode, the etching preserving a thickness of the useful layer, called the base (55; 65), forming the common stand for the pads;
- creating (501; 601; 704) at least one PN junction, such that the useful layer has:
- the first doped zone (54; 64) having a first N or P doping, extending at least in said base; and
- for each pad (52; 62; 72), the second doped zone (53; 63; 73) having a second P or N doping of a different type from that of the first doping, extending at least in the upper region of said pad, on the side of the pad opposite to the base;
the method comprising a further step of doping (502; 604; 701) made so as to form:
- at least one first region (54A; 64A; 74A) having a first doping density, located at least under each of said pads (52; 62; 72); and
- at least one second region (54B; 64B; 74B) located between two neighboring pads, and having a second doping density, higher than the first doping density, each second region (54B; 64B; 74B) being separated from the closest second doped zone (53; 63; 73) by at least one portion of the first region (54A; 64A; 74A),
the method being **characterized in that** the further step of doping is made by ion implantation between two pads, and **in that** the width of the second region decreases when the distance to the lower face of the useful layer decreases.

11. The method according to claim 10, **characterized in that** the step (704) of creating at least one PN junction implements an ion implantation of a donor dopant, and **in that** the further step of doping (701) implements an ion implantation of an acceptor dopant, and **in that** it further comprises the following steps of:
- depositing (702), onto the useful layer, a layer, called a reservoir layer (730), having a cadmium concentration higher than that of the useful layer (70);
- annealing (703) the useful layer (70) covered with the reservoir layer (730) performing a diffusion of the cadmium atoms of the reservoir layer, from the reservoir layer to the useful layer.

12. The method according to claim 11, **characterized by** a step of etching a portion of the reservoir layer (730) located above the pads (72), this step being performed before the annealing (703).

13. The method according to claim 10, **characterized in that** the step (601) of creating at least one PN junction implements an ion implantation of an acceptor dopant onto the side walls (68) and the upper wall (69) of each pad (62), and **in that** it further comprises the following steps of:
- depositing (602), onto the useful layer, a layer, called a reservoir layer (630), having a cadmium concentration higher than that of the useful layer (60);
- annealing (603) the useful layer (60) covered with the reservoir layer (630) performing a diffusion of the cadmium atoms of the reservoir layer, from the reservoir layer to the useful layer.
